# FASCICULE DE BREVET EUROPEEN

(11) **EP 4 092 902 B1**
(45) Date de publication et mention de la délivrance du brevet: **22.10.2025**
(21) Numéro de dépôt: 22167292.6
(22) Date de dépôt: 08.04.2022
(51) Int. Cl.: H02P 3/06, H02H 3/00, H02P 29/02, H02P 29/024

(54) **PROCEDE ET DISPOSITIF DE SURVEILLANCE D APPAREILS DE COUPURE**
VERFAHREN UND VORRICHTUNG ZUR ÜBERWACHUNG VON STROMUNTERBRECHUNGSGERÄTEN
METHOD AND DEVICE FOR MONITORING CUT-OFF DEVICES

(30) Priorité: 21.05.2021 FR 2105327
(43) Date de publication de la demande: 23.11.2022
(73) Titulaire: Schneider Electric Industries SAS, 92500 Rueil-Malmaison (FR)
(72) Inventeur: KRAYNOV, Vladislav, 38100 Grenoble (FR)
(74) Mandataire: Plasseraud IP

(56) Documents cités:
- CN-U- 207 439 671
- JP-B2- 5 787 231

## Description

### Domaine technique

L'invention relève du domaine de la surveillance du fonctionnement d'appareils de coupure tels que des disjoncteurs basse tension soit jusqu'à 1000 Volts en général ou moyenne tension par exemple entre 1000 Volts et 25 000 Volts.

Ces appareils de coupure comportent un mécanisme de commutation pourvu d'un dispositif d'armement d'un ressort de rappel du mécanisme de commutation qui permet de commuter des organes de coupure, tels des contacts, entre une position fermée dans laquelle un courant traverse l'appareil et une position ouverte dans laquelle le courant est interrompu par l'appareil de coupure. Pour réaliser la coupure, un actuateur électromagnétique libère le ressort qui ramène le mécanisme de commutation en position d'ouverture de l'appareil de coupure. Il est souhaitable de pouvoir contrôler le bon fonctionnement tant de l'actuateur électromagnétique que du mécanisme de commutation.
Les documents JP2013257969A et CN207439671U proposent des méthodes de détection de la présence d'un défaut de fonctionnement d'un appareil de coupure.

### Technique antérieure

Il est connu d'équiper de tels appareils de coupure avec des contacts auxiliaires de détection de position des organes de coupure, ainsi que de capteurs de courant ou tension de détection du départ de mouvement du mécanisme de commutation. Ces contacts auxiliaires et ces capteurs permettent de déterminer un début de séquence ou une fin de séquence d'ouverture de l'appareil de coupure à partir d'un changement d'état des contacts auxiliaires, mais ne permettent pas de mesurer le temps nécessaire à l'actuateur électromagnétique de l'appareil de coupure pour initier la mise en mouvement du mécanisme de commutation. De plus il n'est pas non plus possible avec ces contacts ou interrupteurs auxiliaires de mesurer le temps nécessaire à ce mécanisme de commutation pour réellement couper ou rétablir le circuit.

### Problème technique

Savoir distinguer le temps nécessaire à l'actuateur électromagnétique pour initier la mise en mouvement du mécanisme de commutation pour réellement ouvrir ou fermer le circuit électrique est utile dans le cadre de la maintenance des appareils de coupure. En effet, un temps d'initiation de la mise en mouvement du mécanisme de commutation accru peut correspondre à un défaut mineur de l'appareil de coupure sans incidence sur la qualité de la coupure effective alors qu'un mécanisme de commutation trop lent peut conduire à un défaut de coupure du circuit commandé par l'appareil de coupure.

### Exposé de l'invention

Pour ce faire, la présente demande propose un procédé de surveillance d'un appareil de coupure, pourvu d'un mécanisme de commutation, comportant :
a. - une surveillance d'un signal d'alimentation électrique d'un actuateur électromagnétique du mécanisme de commutation pour réaliser une détection du début d'alimentation électrique dudit actuateur,
b. - une surveillance d'une mesure d'intensité de choc au moyen d'un capteur de vibrations au niveau dudit appareil de coupure pour réaliser une détection de la mise en mouvement dudit mécanisme de commutation, le capteur de vibrations fournissant un signal vibratoire en réponse à la mise en mouvement dudit mécanisme de commutation,
c. - une surveillance d'un paramètre représentatif de l'état ouvert ou fermé dudit appareil de coupure pour détecter un changement d'état dudit paramètre, représentatif d'une fin de séquence d'ouverture ou de fermeture dudit appareil de coupure,
et comportant :
d. - un calcul d'un temps T_{ACT} écoulé entre la détection du début d'alimentation électrique dudit actuateur et la détection de la mise en mouvement du mécanisme de commutation dudit appareil de coupure,
e. - un calcul d'un temps T_{M} écoulé entre ladite mise en mouvement du mécanisme de commutation et ladite fin de séquence,
f. une comparaison desdits temps T_{ACT} et T_{M} écoulés à des valeurs seuil prédéterminées respectivement TS_{ACT} et TS_{M} en vue de réaliser un diagnostic sur le fonctionnement de l'appareil de coupure.

Le procédé est ainsi basé directement sur la surveillance de paramètres électriques et physiques directement reliés aux temps de mise en mouvement du mécanisme de commutation et de l'actuateur électromagnétique ce qui permet une mesure précise de ces temps.

Le procédé peut comporter avantageusement une comparaison dudit signal d'alimentation électrique à un seuil S1 représentatif d'un début d'alimentation électrique dudit actuateur.

Le procédé peut comporter avantageusement une comparaison de ladite intensité de choc à un seuil C1 représentatif de la mise en mouvement d'un mécanisme de commutation dudit disjoncteur.

Le signal d'alimentation électrique peut être un courant I_{ACT} d'alimentation de l'actuateur électromagnétique.

Dans un mode de réalisation alternatif, le signal d'alimentation électrique peut être une tension d'alimentation de l'actuateur électromagnétique.

Le paramètre représentatif de l'état ouvert ou fermé dudit appareil de coupure peut être un état logique SW d'un contact auxiliaire du mécanisme de commutation de l'appareil de coupure.

Le procédé peut comporter une alerte de défaut de l'actuateur électromagnétique lorsque le temps T_{ACT} est supérieur à la valeur seuil TS_{ACT}.

Le procédé peut comporter une alerte de défaut de mécanisme de coupure lorsque le temps T_{M} est supérieur à la valeur seuil TS_{M}.

Le procédé peut comporter une analyse de forme d'onde du signal d'alimentation électrique de l'actuateur électromagnétique.

Ceci permet une surveillance du fonctionnement de l'actuateur électromagnétique.

L'invention concerne en outre un dispositif de surveillance du fonctionnement d'un appareil de coupure qui comporte :
a. une interface de mesure pourvue de moyens de prise de signaux sur des liaisons de raccordement d'organes dudit appareil de coupure avec un dispositif de commande dudit appareil de coupure comportant :
   i. au moins un capteur de courant ou de tension sur une desdites liaisons correspondant à une voie d'alimentation d'un actuateur électromagnétique du mécanisme de commutation de l'appareil de coupure,
   ii. au moins un capteur de tension sur une desdites liaisons correspondant à un contact auxiliaire de position ouvert ou fermé de l'appareil de coupure, dit contact auxiliaire de l'appareil de coupure,
b. au moins un capteur de choc configuré pour détecter la mise en action du mécanisme de commutation de l'appareil de coupure, le capteur de choc fournissant un signal vibratoire en réponse à la mise en mouvement dudit mécanisme de commutation,
c. une unité d'acquisition de signaux et de calcul raccordée auxdits moyens de prise de signaux et au capteur de choc et pourvue d'un module d'acquisition desdits signaux, d'un processeur relié audit module d'acquisition et une mémoire renfermant un ensemble d'instructions pour la mise en œuvre du procédé selon l'invention lorsque lesdites instructions sont exécutées par ledit processeur.

Le dispositif de surveillance est aisé à mettre en œuvre et ne perturbe pas le fonctionnement de l'appareil de coupure.

Selon un mode de réalisation avantageux, ladite interface comporte un premier connecteur, complémentaire d'une embase de connexion d'une fiche de raccordement dudit appareil de coupure à un dispositif de commande dudit appareil

Selon un mode de réalisation avantageux, ladite interface comporte un premier connecteur, complémentaire d'une embase de connexion d'une fiche de raccordement dudit appareil de coupure à un dispositif de commande dudit appareil de coupure, un second connecteur reprenant la configuration de ladite embase et regroupe lesdits moyens de prise de signaux, entre lesdits premier connecteur et second connecteur, ledit circuit électronique comportant des liaisons point à point entre les points de connexion en regard desdits premiers et second connecteurs.

Ceci permet un équipement rapide d'appareils de coupure déjà installés sans nécessité de modifier le faisceau auquel ils sont raccordés.

Selon un mode de réalisation avantageux, le dispositif de surveillance comporte une alimentation réalisée au moyen d'une dérivation raccordée sur une liaison d'alimentation d'un capteur de l'appareil de coupure.

Ainsi aucun câblage supplémentaire pour alimenter le dispositif ne doit être réalisé.

L'unité d'acquisition de signaux et de calcul comporte avantageusement un dispositif de communication sans fil ou filaire avec un concentrateur de pilotage et de surveillance dudit appareil de coupure et adapté à transmettre audit concentrateur des données de surveillance et des paramètres de fonctionnement dudit appareil de coupure générés par ladite unité d'acquisition de signaux et de calcul à partir de mesures réalisées au moyen desdits capteurs.

Ainsi l'unité d'acquisition de signaux et de calcul effectue en local les mesures et les calculs nécessaires à détecter des défauts sur l'appareil de coupure ou son système de commande et transmet les résultats au concentrateur qui gère une pluralité de dispositifs de coupure.

Le capteur de choc peut être disposé dans un boîtier de l'unité d'acquisition de signaux et de calcul. Selon cette réalisation, ce boîtier est fixé directement sur le dispositif de coupure.

De manière alternative, le capteur de choc peut être disposé sur l'appareil de coupure et relié à l'unité d'acquisition de signaux et de calcul par une liaison filaire.

L'invention concerne aussi un programme informatique comportant des instructions pour la mise en œuvre de tout ou partie du procédé de l'invention lorsque ce programme est exécuté par un processeur.

### Brève description des dessins

D'autres caractéristiques, détails et avantages de l'invention apparaîtront à la lecture de la description détaillée ci-après d'exemples de réalisation non limitatifs, et à l'analyse des dessins annexés, sur lesquels :
[Fig. 1] montre une représentation schématique d'un dispositif selon un premier exemple de réalisation;
[Fig. 2] montre une représentation schématique d'un dispositif selon un second exemple de réalisation;
[Fig. 3] montre une représentation schématique de raccordement d'un dispositif de surveillance adapté pour l'invention;
[Fig. 4] représente un logigramme d'étapes de l'invention ;
[Fig. 5] montre une représentation de signaux utilisés dans le cadre de l'invention pour un premier type d'actuateur électromagnétique ;
[Fig. 6] montre une représentation de signaux utilisés dans le cadre de l'invention pour un second type d'actuateur électromagnétique.

### Description des modes de réalisation

Les dessins et la description ci-après contiennent des éléments pouvant non seulement servir à mieux faire comprendre la présente invention, mais aussi contribuer à sa définition, le cas échéant.

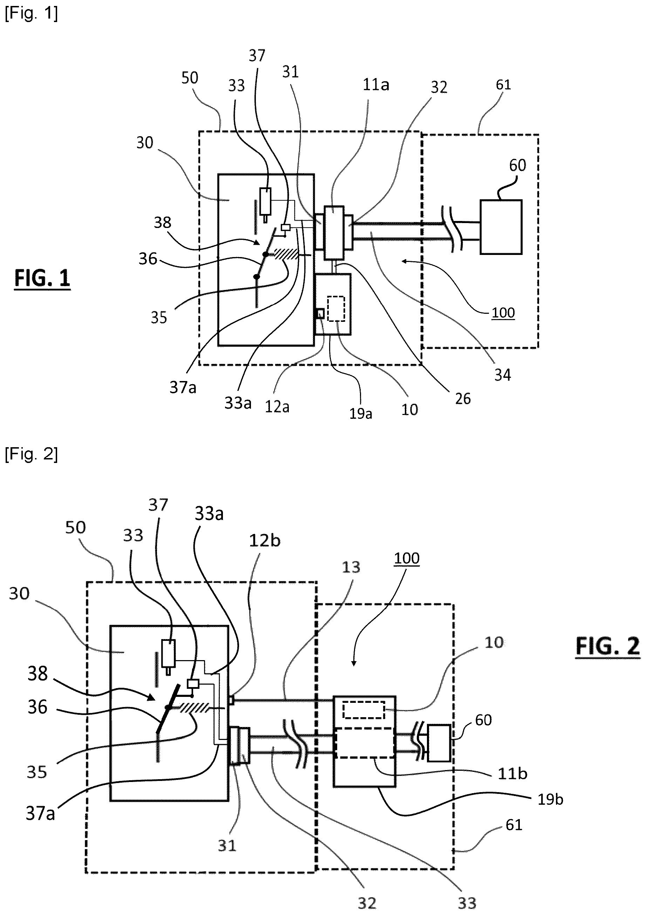

La figure 1 représente de façon schématique un dispositif de commande 60, par exemple disposé dans une armoire 61, relié électriquement à un appareil de coupure 30. L'appareil de coupure 30, par exemple disposé dans une armoire électrique 50, est configuré pour ouvrir ou fermer un circuit électrique, non représenté, au travers d'un organe de coupure 36.

Le dispositif de commande 60 est configuré pour commander l'appareil de coupure 30 en alimentant un actuateur électromagnétique 33. L'actuateur électromécanique 33 pilote un mécanisme de commutation 38 qui permet de réaliser alternativement un état ouvert ou un état fermé de l'organe de coupure 36 de l'appareil de coupure 30.De façon connue en soi, lorsqu'un appareil de coupure 30 doit ouvrir ou fermer le circuit électrique, le dispositif de commande 60 alimente, au travers d'une liaison 33a l'actuateur électromagnétique 33 de l'appareil de coupure 30, qui libère un ressort 35 du mécanisme de commutation 38 pour ouvrir, ou fermer le cas échéant l'organe de coupure 36. Pour obtenir la coupure, il y a donc une durée de commande de l'actuateur magnétique 33 pour libérer le ressort 35 du mécanisme de commutation 38 puis une durée d'actionnement pendant laquelle le mécanisme de commutation déplace l'organe de coupure de la position fermée à ouverte ou l'inverse. Ces deux durées, à savoir la durée de commande et la durée d'actionnement, corresponde ensemble à la durée de mise en mouvement du mécanisme de commutation 38.

L'appareil de coupure 30 est relié au dispositif de commande 60 par un faisceau de raccordement 34 par lequel transite une alimentation de l'actuateur électromagnétique 33 .

L'invention propose d'utiliser des signaux transitant par le faisceau de raccordement 34 ainsi qu'une détection de choc pour analyser le fonctionnement du mécanisme de commutation 38 piloté par l'actuateur électromagnétique 33.

Selon la figure 1, l'appareil de coupure 30 comporte un contact auxiliaire 37 de détection de la position ouverte ou fermée de l'organe de coupure 36 relié via le faisceau de raccordement 34 au dispositif de commande 60. Le faisceau de raccordement 34 peut aussi comporter une ou plusieurs liaisons d'alimentation pour un ou plusieurs capteurs non représentés.

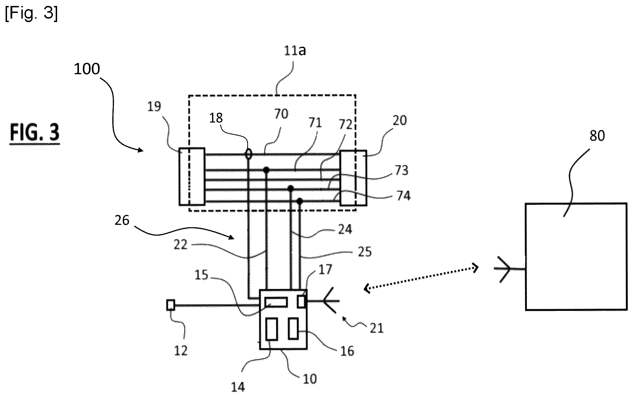

La figure 3 représente schématiquement un exemple de réalisation d'un dispositif de surveillance 100 qui comporte une interface de mesure 11a pourvue de moyens de prise de signaux sur des liaisons 70,71, 72, 73, 74 de raccordement de l'appareil de coupure 30 au dispositif de commande 60. Plus précisément, dans cet exemple de réalisation, l'interface de mesure 11a comporte le premier connecteur 19, complémentaire de l'embase 31 et le second connecteur 20 complémentaire de la fiche 32. L'interface de mesure comporte des liaisons point à point 70, 71, 72, 73, 74 entre des points de connexion en regard desdits premiers et second connecteurs. L'interface de mesure 11a regroupe en outre lesdits moyens de prise de signaux qui sont transmis une l'unité d'acquisition de signaux et de calcul 10 par l'intermédiaire d'un faisceau 26.

L'unité d'acquisition de signaux et de calcul 10 est pourvue d'un module d'acquisition 15 desdits signaux entre une entrée pour le capteur 12 et un processeur 14 relié audit module d'acquisition et une mémoire 16 pouvant comporter de la mémoire en lecture seule, dans lesquelles sont comprises les instructions du procédé et de la mémoire vive de travail de manière connue.

Le dispositif de surveillance 100 est adapté pour être disposé entre l'appareil de coupure et le dispositif de commande, notamment connecté électriquement à l'appareil de coupure et au dispositif de commande respectivement par un premier connecteur 19 et un second connecteur 20.

Les signaux utilisés dans le cadre de l'invention un signal d'alimentation électrique, notamment de tension ou de courant, de l'actuateur électromagnétique 33, un signal représentatif de l'état ouvert ou fermé de l'appareil de coupure provenant du contact auxiliaire 37 de l'appareil de coupure 30 et un signal d'une mesure d'intensité de choc provenant d'un capteur de choc 12.

Dans le cas où le signal d'alimentation est un signal représentatif d'une mesure de courant, le dispositif de surveillance 100 schématisé en figure 3 comporte un capteur de courant 18, par exemple un capteur de type à effet Hall ou à enroulement de Rogowski sur la liaison 70 correspondant à une voie d'alimentation de l'actuateur électromagnétique de l'appareil de coupure. Une telle mesure de courant a l'avantage de se faire sur un seul fil d'alimentation de ne pas risquer de perturber l'alimentation de l'actuateur électromagnétique, ni de risquer de surtensions au niveau du dispositif de surveillance 100. Dans le cas où le signal d'alimentation est un signal représentatif d'une mesure de tension, la mesure peut être faite au moyen d'un piquage sur ladite voie d'alimentation, mais dans ce cas il est préférable de réaliser la mesure entre les fils aller et retour de l'alimentation de l'actuateur électromagnétique.

Un capteur de tension 22, tel qu'un piquage sur la liaison 71est adapté pour détecter un changement d'état ouvert ou fermé de l'appareil de coupure.

Un capteur de choc 12 est disposé sur l'appareil de coupure et est configuré pour mesurer une intensité de choc correspondant à la mise en mouvement du mécanisme de commutation 38 de l'appareil de coupure.

Le dispositif de surveillance 100 comporte une unité d'acquisition de signaux et de calcul 10 raccordée auxdits moyens de prise de signaux et au capteur de choc.

Le dispositif de surveillance 100 peut avoir plusieurs configurations et, dans un premier mode de réalisation selon la figure 1, l'interface de mesure 11a et l'unité d'acquisition de signaux et de calcul 10 du dispositif de surveillance sont, comme en figure 3, dissociées et reliées par un faisceau électrique 26 par lequel transitent les signaux de mesure.

L'interface 11a est disposée entre une embase 31 de l'appareil de coupure et une fiche 32.

Dans cette configuration, l'unité d'acquisition de signaux et de calcul est logée dans un boîtier 19a fixé sur l'appareil de coupure 30 et le capteur de choc 12a est intégré audit boîtier 19a qui est disposé en contact avec l'appareil de coupure.

Un second exemple de réalisation est décrit en figure 2. Dans cet exemple, le dispositif de surveillance 100 est par exemple déporté dans l'armoire 61 logeant le dispositif de commande 60 et se raccorde sur un faisceau 33 raccordant le dispositif de commande à l'appareil de coupure. Le dispositif de surveillance comporte une interface de liaison 11b intégrée à un boîtier 19b renfermant l'unité d'acquisition de signaux et de calcul 10. L'interface de liaison 11b est raccordée au sein du boîtier 19b à l'unité d'acquisition de signaux et de calcul 10.

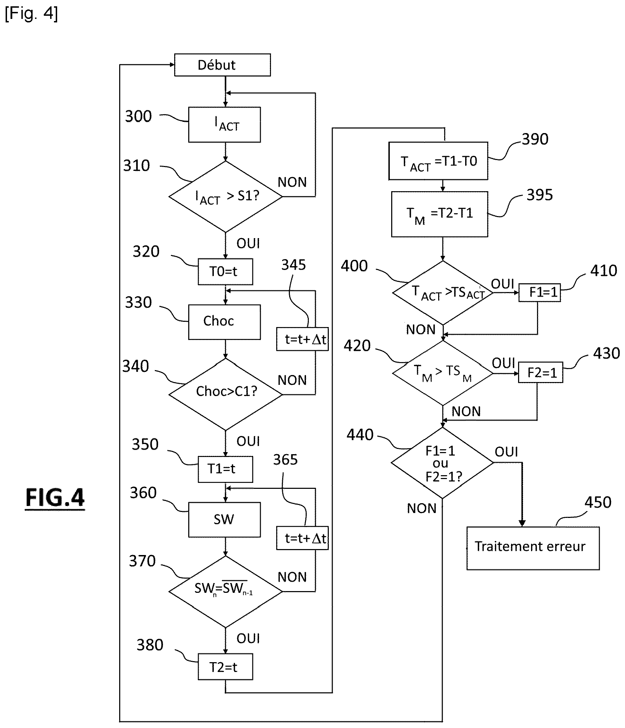

La figure 4 représente un logigramme comportant des étapes d'un procédé de surveillance de l'appareil de coupure 30. Ce procédé peut être intégré dans un procédé plus global de surveillance d'une pluralité d'appareils de coupure gérés au niveau d'un poste basse ou moyenne tension par exemple.

Le procédé comporte une surveillance 300 d'un signal d'alimentation électrique, ici un courant I_{ACT} de commande de l'actuateur électromagnétique 33, pour réaliser une détection du début d'alimentation électrique dudit actuateur électromagnétique 33. Cette surveillance peut être réalisée au sein de l'unité d'acquisition de signaux et de calcul 10. Cette surveillance est répétée tant que le courant I_{ACT} ne dépasse pas une valeur seuil S1 à l'étape 310, la mesure est répétée.

Si le courant I_{ACT} a dépassé la valeur seuil S1, le procédé comporte une étape de mémorisation de la valeur de temps T0 à laquelle le courant a dépassé la valeur seuil S1 à l'étape 320.

Le procédé comporte ensuite une surveillance d'une intensité de choc 330 au moyen d'une mesure par le capteur de vibrations 12. La mesure peut être une mesure d'intensité de vibrations au niveau dudit appareil de coupure permettant une détection de la mise en mouvement dudit mécanisme de commutation. Tant que la mesure d'intensité de choc reste sous un seuil C1 à l'étape 340, la surveillance se prolonge et un compteur de temps t est incrémenté à l'étape 345.

Lorsque la mesure d'intensité de choc dépasse le seuil C1, la valeur de temps T1 est mémorisée à l'étape 350.

Le procédé comporte ensuite à l'étape 360 une surveillance d'un paramètre SW représentatif de l'ouverture ou de la fermeture dudit appareil de coupure, par exemple un état logique représentatif de l'état ouvert ou fermé de l'organe de coupure. Le procédé détecte à l'étape 370 un changement d'état dudit paramètre SW, ce qui est représentatif ici d'une fin de séquence d'ouverture ou de fermeture dudit appareil de coupure.

Tant que le changement d'état n'est pas détecté, le compteur de temps s'incrémente à l'étape 365.

Une fois le contact auxiliaire activé, le temps T2 représentatif de la fin de séquence d'ouverture ou de fermeture est mémorisé.

Le procédé comporte alors un calcul 390 d'un temps T_{ACT} écoulé entre la détection du début d'alimentation électrique dudit actuateur et la détection de la mise en mouvement du mécanisme de commutation. Le procédé comprend également un calcul 395 d'un temps T_{M} écoulé entre ladite mise en mouvement du mécanisme de commutation et ladite fin de séquence.

Ensuite le procédé de surveillance peut comporter une comparaison aux étapes 400, 420 desdits temps T_{ACT} et T_{M} écoulés à des valeurs seuil prédéterminées respectivement TS_{ACT} et TS_{M} en vue de réaliser un diagnostic sur le fonctionnement de l'appareil de coupure. Ces étapes peuvent être réalisées au sein de l'unité d'acquisition de signaux et de calcul 10 mais peuvent aussi être réalisées dans un calculateur (non représentée) du dispositif de commande 60 de l'appareil de coupure ou un concentrateur 80 d'un poste de commande local ou déporté auquel l'unité d'acquisition de signaux et de calcul est reliée, soit de façon filaire telle qu'une liaison Ethernet soit sans fil 21 telle qu'une liaison WiFi, Zigbee, Bluetooth ou autre.

Lorsque le temps T_{ACT} est supérieur à la valeur seuil TS_{ACT} prédéfinie selon le type d'appareil de coupure, une alerte 410 de défaut de l'actuateur électromagnétique est émise par exemple au moyen d'un drapeau logique F1 initialisé à l'étape 410 lorsque T_{ACT} est supérieur à TS_{ACT} à l'étape 400. Une telle alerte peut générer une demande d'intervention lors d'une opération de maintenance.

Lorsque le temps T_{M} est supérieur à la valeur seuil TS_{M}, une alerte 430 de défaut du mécanisme de commutation est générée, par exemple au moyen d'un drapeau logique F2 initialisé à l'étape 430 lorsque T_{M} est supérieur à TS_{M} à l'étape 420, et, selon le seuil TS_{M} choisi, une demande d'intervention urgente peut être générée du fait qu'un temps d'actionnement trop long du mécanisme de commutation peut conduire à ce que la coupure ne se fasse pas et un causer un disfonctionnement grave de l'appareil de coupure.

Ainsi, le procédé permet d'effectuer un diagnostic de la fonction de coupure de l'appareil de coupure.

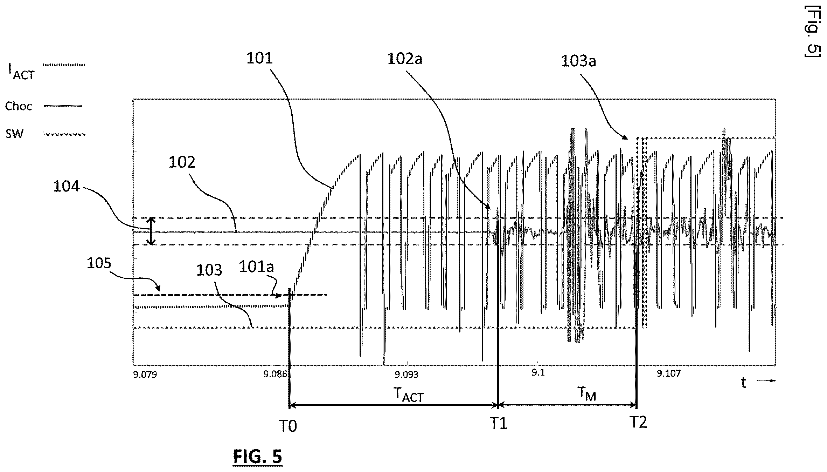

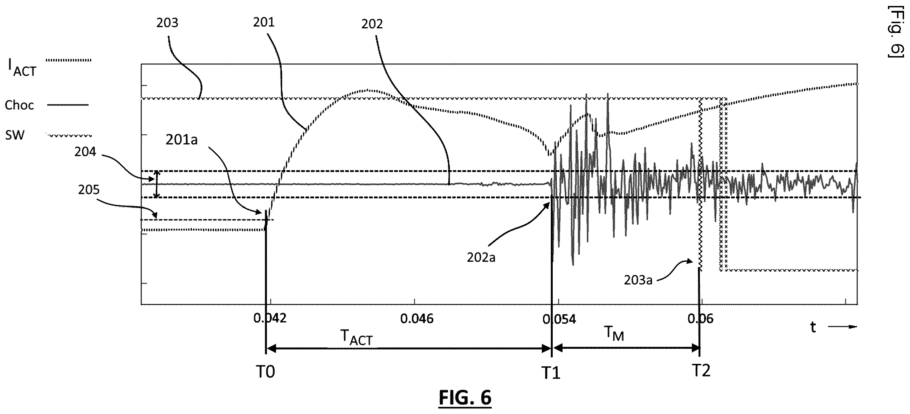

Les figures 5 et 6 illustrent des types de signaux utilisés dans le cadre du procédé.

La figure 5 correspond à un dispositif de surveillance dans lequel l'actuateur électromagnétique comprend une bobine pilotée en modulation de largeur d'impulsion (PWM). En particulier, la figure 5 représente les signaux remis à l'échelle pour tenir sur le même graphique montrant les temps T_{ACT} temps de mise en fonction de l'actuateur et T_{M} temps de mouvement du mécanisme de commutation. On illustre ainsi le courant I_{ACT} 101 avec la détection de début d'alimentation 101a selon le seuil S1 105, le signal vibratoire Choc 102 selon le seuil C1 104 et une valeur 102a représentative de l'intensité du choc de mise en mouvement du mécanisme de commutation ainsi que le signal logique 103 du contact auxiliaire qui va donner le paramètre représentatif de l'état ouvert ou fermé de l'appareil de coupure et la détection 103a du changement d'état de ce contact auxiliaire par passage de la valeur logique 0 vers 1.

La figure 6 correspond à un actuateur électromagnétique dont la bobine est pilotée par un courant analogique et représente les signaux remis à l'échelle pour tenir sur le même graphique montrant les temps T_{ACT} temps de mise en fonction de l'actuateur et T_{M} temps de mouvement du mécanisme et comportant le courant bobine I_{ACT} 201 avec la détection de début d'alimentation 201a selon le seuil S1 205, le signal vibratoire Choc 202 avec une plage de seuil C1 204 et une valeur 102a représentative du choc de début de mouvement du mécanisme de coupure ainsi que le signal logique 203 du contact auxiliaire ici inversé et la détection 203a du changement d'état du contact auxiliaire par passage de la valeur logique 1 vers 0.

La surveillance des signaux de la présente invention peut aussi comporter une analyse de forme d'onde du signal d'alimentation électrique 101, 201 de l'actuateur électromagnétique pour en surveiller ses caractéristiques comme sa valeur crête ou moyenne.

L'invention s'applique plus particulièrement aux appareils de coupure basse et moyenne tension pour des postes d'alimentation, tels que des postes d'alimentations de locaux et de machines industriels.

L'invention ne se limite pas aux exemples décrits ci-avant, seulement à titre d'exemple, mais elle englobe toutes les variantes que pourra envisager l'homme de l'art dans le cadre de la protection recherchée et notamment comme dit précédemment, le signal d'alimentation électrique de l'actuateur peut être une tension d'alimentation de l'actuateur électromagnétique 33 au lieu de son courant d'alimentation et le procédé associé au dispositif peut comporter des surveillances d'autres paramètres de fonctionnement de l'appareil de coupure selon le câblage de l'interface 11a ou 11b.

## Revendications

1. Procédé de surveillance d'un appareil de coupure (30), pourvu d'un mécanisme de commutation (38), comportant:
- une surveillance (300) d'un signal d'alimentation électrique (101, 201) d'un actuateur électromagnétique (33) du mécanisme de commutation pour réaliser une détection du début d'alimentation électrique (101a, 201a) dudit actuateur,
- une surveillance (330) d'une mesure d'intensité de choc (102, 202) au moyen d'un capteur de vibrations (12) au niveau dudit appareil de coupure pour réaliser une détection de la mise en mouvement (102a, 202a) dudit mécanisme de commutation, le capteur de vibrations (12) fournissant un signal vibratoire en réponse à la mise en mouvement dudit mécanisme de commutation,
- une surveillance (360) d'un paramètre représentatif de l'état ouvert ou fermé (103, 203) dudit appareil de coupure pour détecter (370) un changement d'état (103a, 203a) dudit paramètre, représentatif d'une fin de séquence d'ouverture dudit appareil de coupure,
le procédé étant **caractérisé en ce qu'**il comporte:
- un calcul (390) d'un temps T_{ACT} écoulé entre la détection du début d'alimentation électrique dudit actuateur et la détection de la mise en mouvement du mécanisme de commutation dudit appareil de coupure,
- un calcul (395) d'un temps T_{M} écoulé entre ladite mise en mouvement du mécanisme de commutation et ladite fin de séquence,
- une comparaison (400, 420) desdits temps T_{ACT} et T_{M} écoulés à des valeurs seuil prédéterminées respectivement TS_{ACT} et TS_{M} en vue de réaliser un diagnostic sur le fonctionnement de l'appareil de coupure.

2. Procédé de surveillance d'un appareil de coupure selon la revendication 1 comportant une comparaison (310) dudit signal d'alimentation électrique à un seuil S1 (105, 205) représentatif d'un début d'alimentation électrique dudit actuateur.

3. Procédé de surveillance d'un appareil de coupure selon la revendication 1 ou 2 comportant une comparaison (340) de ladite intensité de choc à un seuil C1 (104, 204) représentatif de la mise en mouvement d'un mécanisme de coupure dudit disjoncteur

4. Procédé de surveillance d'un appareil de coupure selon la revendication 1, 2 ou 3, pour lequel le signal d'alimentation électrique (101, 201) est un courant I_{ACT} d'alimentation de l'actuateur électromagnétique (33).

5. Procédé de surveillance d'un appareil de coupure selon la revendication 1, 2 ou 3, pour lequel le signal d'alimentation électrique (101, 201) est une tension d'alimentation de l'actuateur électromagnétique (33).

6. Procédé de surveillance d'un appareil de coupure selon l'une quelconque des revendications précédentes, pour lequel le paramètre représentatif de l'état ouvert ou fermé (103, 203) dudit appareil de coupure est un état logique SW d'un contact auxiliaire du mécanisme d'ouverture de l'appareil de coupure.

7. Procédé de surveillance d'un appareil de coupure selon la revendication 1 comportant une alerte (410) de défaut de l'actuateur électromagnétique lorsque le temps T_{ACT} est supérieur à la valeur seuil TS_{ACT}.

8. Procédé de surveillance d'un appareil de coupure selon la revendication 1 ou 7, comportant une alerte (430) de défaut de mécanisme de coupure lorsque le temps T_{M} est supérieur à la valeur seuil TS_{M}.

9. Dispositif de surveillance du fonctionnement d'un appareil de coupure, comportant :
a. une interface de mesure (11a, 11b) pourvue de moyens de prise de signaux sur des liaisons de raccordement d'organes dudit appareil de coupure avec un dispositif de commande dudit appareil de coupure comportant :
i. au moins un capteur de courant (18) ou de tension sur une desdits liaisons (70) correspondant à une voie d'alimentation d'un actuateur électromagnétique (33) du mécanisme de commutation de l'appareil de coupure,
ii. au moins un capteur de tension (22) sur une desdites liaisons (71) correspondant à un contact auxiliaire (37) de l'appareil de coupure
b. au moins un capteur de choc (12, 12a, 12b) configuré pour détecter la mise en action du mécanisme de commutation (38) de l'appareil de coupure, le capteur de choc fournissant un signal vibratoire en réponse à la mise en mouvement dudit mécanisme de commutation,
c. une unité d'acquisition de signaux et de calcul (10) raccordée auxdits moyens de prise de signaux et au capteur de choc et pourvue d'un module (15) d'acquisition desdits signaux, d'un processeur (14) relié audit module d'acquisition et une mémoire (16) renfermant un ensemble d'instructions pour la mise en œuvre du procédé selon l'une quelconque des revendications 1 à 8 lorsque lesdites instructions sont exécutées par ledit processeur.

10. Dispositif de surveillance selon la revendication 9 pour lequel ladite interface (11a) comporte un premier connecteur (19), complémentaire d'une embase (31) de connexion d'une fiche (32) de raccordement dudit appareil de coupure (30) à un dispositif de commande (60) dudit appareil de coupure, un second connecteur (20) reprenant la configuration de ladite embase (31) et regroupe lesdits moyens de prise de signaux, entre lesdits premier connecteur et second connecteur, ledit circuit électronique comportant des liaisons point à point (70, 71, 72, 73, 74) entre les points de connexion en regard desdits premiers et second connecteurs.

11. Dispositif de surveillance selon la revendication 9 ou 10 comportant une alimentation réalisée au moyen d'une dérivation (24, 25) raccordée sur une liaison d'alimentation (73, 74) d'un capteur de l'appareil de coupure.

12. Dispositif de surveillance selon l'une quelconque des revendications 9 à 11, pour lequel l'unité d'acquisition de signaux et de calcul comporte un dispositif de communication (17) sans fil ou filaire avec un concentrateur (80) de pilotage et de surveillance dudit appareil de coupure et adapté à transmettre audit concentrateur des données de surveillance et des paramètres de fonctionnement dudit appareil de coupure générés par ladite unité d'acquisition de signaux et de calcul à partir de mesures réalisées au moyen desdits capteurs.

13. Dispositif de surveillance selon l'une quelconque des revendications 9 à 12 pour lequel ledit capteur de choc (12a, 12b) est disposé dans un boîtier (19a) de l'unité d'acquisition de signaux et de calcul (10) ou disposé sur l'appareil de coupure et relié à l'unité d'acquisition de signaux et de calcul par une liaison filaire.

14. Programme informatique comportant des instructions pour la mise en œuvre de tout ou partie du procédé selon l'une quelconque des revendications 1 à 8 lorsque ce programme est exécuté par un processeur.

## Patentansprüche

1. Verfahren zur Überwachung einer Unterbrechungsvorrichtung (30), die mit einem Schaltmechanismus (38) ausgestattet ist, das Folgendes aufweist:
- Überwachen (300) eines Stromversorgungssignals (101, 201) eines elektromagnetischen Aktuators (33) des Schaltmechanismus, um eine Erkennung des Beginns der Stromversorgung (101a, 201a) des Aktuators durchzuführen,
- Überwachen (330) einer Stoßintensitätsmessung (102, 202) mittels eines Vibrationssensors (12) an der Unterbrechungsvorrichtung, um eine Erkennung der Ingangsetzung (102a, 202a) des Schaltmechanismus durchzuführen, wobei der Vibrationssensor (12) ein Vibrationssignal als Reaktion auf die Ingangsetzung des Schaltmechanismus liefert,
- Überwachen (360) eines Parameters, der für den geöffneten oder geschlossenen Zustand (103, 203) der Unterbrechungsvorrichtung repräsentativ ist, um eine Zustandsänderung (103a, 203a) des Parameters zu erkennen (370), die für ein Ende einer Öffnungssequenz der Unterbrechungsvorrichtung repräsentativ ist,
wobei das Verfahren **dadurch gekennzeichnet ist, dass** es Folgendes aufweist:
- Berechnen (390) einer Zeit T_{ACT}, die zwischen der Erkennung des Beginns der Stromversorgung des Aktuators und der Erkennung der Ingangsetzung des Schaltmechanismus der Unterbrechungsvorrichtung abgelaufen ist,
- Berechnen (395) einer Zeit T_{M}, die zwischen der Ingangsetzung des Schaltmechanismus und dem Ende der Sequenz abgelaufen ist,
- Vergleichen (400, 420) der abgelaufenen Zeiten T_{ACT} und T_{M} mit jeweils vorbestimmten Schwellenwerten TS_{ACT} und TS_{M}, um eine Diagnose über die Funktion der Unterbrechungsvorrichtung durchzuführen.

2. Verfahren zur Überwachung einer Unterbrechungsvorrichtung nach Anspruch 1, das ein Vergleichen (310) des Stromversorgungssignals mit einem Schwellenwert S1 (105, 205) aufweist, der für einen Beginn der Stromversorgung des Aktuators repräsentativ ist.

3. Verfahren zur Überwachung einer Unterbrechungsvorrichtung nach Anspruch 1 oder 2, das ein Vergleichen (340) der Stoßintensität mit einem Schwellenwert C1 (104, 204) aufweist, der für die Ingangsetzung eines Unterbrechungsmechanismus des Leistungsschalters repräsentativ ist

4. Verfahren zur Überwachung einer Unterbrechungsvorrichtung nach Anspruch 1, 2 oder 3, wobei das Stromversorgungssignal (101, 201) ein Versorgungsstrom I_{ACT} des elektromagnetischen Aktuators (33) ist.

5. Verfahren zur Überwachung einer Unterbrechungsvorrichtung nach Anspruch 1, 2 oder 3, wobei das Stromversorgungssignal (101, 201) eine Versorgungsspannung des elektromagnetischen Aktuators (33) ist.

6. Verfahren zur Überwachung einer Unterbrechungsvorrichtung nach einem der vorhergehenden Ansprüche, wobei der Parameter, der für den geöffneten oder geschlossenen Zustand (103, 203) der Unterbrechungsvorrichtung repräsentativ ist, ein logischer Zustand SW eines Hilfskontakts des Öffnungsmechanismus der Unterbrechungsvorrichtung ist.

7. Verfahren zur Überwachung einer Unterbrechungsvorrichtung nach Anspruch 1, das eine Fehlermeldung (410) des elektromagnetischen Aktuators aufweist, wenn die Zeit T_{ACT} größer als der Schwellenwert TS_{ACT} ist.

8. Verfahren zur Überwachung einer Unterbrechungsvorrichtung nach Anspruch 1 oder 7, umfassend eine Fehlermeldung (430) für einen Unterbrechungsmechanismus, wenn die Zeit T_{M} größer als der Schwellenwert TS_{M} ist.

9. Einrichtung zur Überwachung des Betriebs einer Unterbrechungsvorrichtung, die Folgendes aufweist:
a. eine Messschnittstelle (11a, 11b), die mit Mitteln zum Erfassen von Signalen an Anschlussverbindungen von Organen der Unterbrechungsvorrichtung mit einer Steuereinrichtung der Unterbrechungsvorrichtung, die Folgendes aufweist:
i. mindestens einen Strom- (18) oder Spannungssensor an einer der Verbindungen (70), die einem Versorgungspfad eines elektromagnetischen Aktuators (33) des Schaltmechanismus der Unterbrechungsvorrichtung entspricht,
ii. mindestens einen Spannungssensor (22) an einer der Verbindungen (71), die einem Hilfskontakt (37) der Unterbrechungsvorrichtung entsprechen
b. mindestens einen Aufprallsensor (12, 12a, 12b), der so konfiguriert ist, dass er die Betätigung des Schaltmechanismus (38) der Unterbrechungsvorrichtung erkennt, wobei der Aufprallsensor ein Vibrationssignal als Reaktion auf die Ingangsetzung des Schaltmechanismus liefert,
c. eine Signalerfassungs- und Recheneinheit (10), die an die Signalerfassungsmittel und den Aufprallsensor angeschlossen ist und mit einem Modul (15) zur Erfassung der Signale, einem mit dem Erfassungsmodul verbundenen Prozessor (14) und einem Speicher (16) ausgestattet ist, der eine Reihe von Anweisungen für die Durchführung des Verfahrens nach einem der Ansprüche 1 bis 8 enthält, wenn die Anweisungen von dem Prozessor ausgeführt werden.

10. Überwachungsvorrichtung nach Anspruch 9, wobei die Schnittstelle (11a) einen ersten Anschluss (19), der komplementär zu einer Anschlussbuchse (31) für einen Anschlussstecker (32) der Unterbrechungsvorrichtung (30) mit einer Steuereinrichtung (60) der Unterbrechungsvorrichtung ist, sowie einen zweiten Anschluss (20) umfasst, der die Konfiguration der Buchse (31) übernimmt und die Signalerfassungsmittel zwischen dem ersten Anschluss und dem zweiten Anschluss zusammenfasst, wobei die elektronische Schaltung Punkt-zu-Punkt-Verbindungen (70, 71, 72, 73, 74) zwischen den Anschlusspunkten umfasst, die dem ersten und dem zweiten Anschluss gegenüberliegen.

11. Überwachungsvorrichtung nach Anspruch 9 oder 10, die eine Stromversorgung umfasst, die mittels einer Abzweigung (24, 25) realisiert ist, die an eine Versorgungsverbindung (73, 74) eines Sensors der Unterbrechungsvorrichtung angeschlossen ist.

12. Überwachungsvorrichtung nach einem der Ansprüche 9 bis 11, wobei die Signalerfassungs- und Recheneinheit eine drahtlose oder drahtgebundene Kommunikationseinrichtung (17) mit einem Konzentrator (80) zur Steuerung und Überwachung der Unterbrechungsvorrichtung aufweist und dazu geeignet ist, an den Konzentrator Überwachungsdaten und Betriebsparameter der Unterbrechungsvorrichtung zu übermitteln, die von der Signalerfassungs- und Recheneinheit aus Messungen erzeugt werden, die mittels der Sensoren durchgeführt werden.

13. Überwachungsvorrichtung nach einem der Ansprüche 9 bis 12, wobei der Aufprallsensor (12a, 12b) in einem Gehäuse (19a) der Signalerfassungs- und Recheneinheit (10) angeordnet oder an der Unterbrechungsvorrichtung angeordnet und über eine drahtgebundene Verbindung mit der Signalerfassungs- und Recheneinheit verbunden ist.

14. Computerprogramm, das Anweisungen zum Durchführen des gesamten oder eines Teils des Verfahrens nach einem der Ansprüche 1 bis 8 umfasst, wenn dieses Programm von einem Prozessor ausgeführt wird.

## Claims

1. Method for monitoring a disconnecting apparatus (30), provided with a switching mechanism (38), comprising:
- monitoring (300) an electrical supply signal (101, 201) of an electromagnetic actuator (33) of the switching mechanism to detect the beginning of electrical supply (101a, 201a) of said actuator,
- monitoring (330) a shock intensity measurement (102, 202) by means of a vibration sensor (12) at said disconnecting apparatus to detect the start of movement (102a, 202a) of said switching mechanism, the vibration sensor (12) providing a vibration signal in response to the start of movement of said switching mechanism,
- monitoring (360) a parameter representative of the open or closed state (103, 203) of said disconnecting apparatus to detect (370) a change of state (103a, 203a) of said parameter, representative of an end of an opening sequence of said disconnecting apparatus,
the method being **characterised in that** it comprises:
- calculating (390) a time T_{ACT} elapsed between the detection of the start of power supply of said actuator and the detection of the start of movement of the switching mechanism of said disconnecting apparatus,
- calculating (395) a time T_{M} elapsed between said start of movement of the switching mechanism and said end of sequence,
- comparing (400, 420) said elapsed times T_{ACT} and T_{M} with predetermined threshold values TS_{ACT} and TS_{M} respectively in order to perform a diagnosis on the operation of the disconnecting apparatus.

2. Method for monitoring a disconnecting apparatus according to claim 1, comprising comparing (310) said power supply signal with a threshold S1 (105, 205) representative of a start of power supply of said actuator.

3. Method for monitoring a disconnecting apparatus according to claim 1 or 2, comprising a comparison (340) of said shock intensity with our a threshold C1 (104, 204) representative of the start of movement of a disconnecting mechanism of said circuit breaker

4. Method for monitoring a disconnecting apparatus according to claim 1, 2 or 3, wherein the power supply signal (101, 201) is a current I_{ACT} for supplying the electromagnetic actuator (33).

5. Method for monitoring a disconnecting apparatus according to claim 1, 2 or 3, wherein the power supply signal (101, 201) is a supply voltage of the electromagnetic actuator (33).

6. Method for monitoring a disconnecting apparatus according to any one of the preceding claims, wherein the parameter representative of the open or closed state (103, 203) of said disconnecting device is a logic state SW of an auxiliary contact of the opening mechanism of the disconnecting apparatus.

7. Method for monitoring a disconnecting apparatus according to claim 1, comprising an alert (410) for a fault of the electromagnetic actuator when the time T_{ACT} is greater than the threshold value TS_{ACT}.

8. Method for monitoring a disconnecting apparatus according to claim 1 or 7, comprising a disconnecting-mechanism fault alert (430) when the time T_{M} is greater than the threshold value TS_{M}.

9. Device for monitoring the operation of a switching device, comprising:
a. a measurement interface (11a, 11b) provided with means for picking up signals on links for connecting said disconnecting apparatus with a control device of said disconnecting device comprising:
i. at least one current (18) or voltage sensor on one of said links (70) corresponding to a supply path of an electromagnetic actuator (33) of the switching mechanism of the disconnecting apparatus,
ii. at least one voltage sensor (22) on one of said links (71) corresponding to an auxiliary contact (37) of the disconnecting apparatus
b. at least one shock sensor (12, 12a, 12b) configured to detect the actuation of the switching mechanism (38) of the disconnecting apparatus, the shock sensor providing a vibratory signal in response to the start of movement of said switching mechanism,
c. a signal acquisition and computing unit (10) connected to said signal acquisition means and the shock sensor and provided with a module (15) for acquiring said signals, a processor (14) connected to said acquisition module and a memory (16) containing a set of instructions for implementing the method according to any one of claims 1 to 8 when said instructions are executed by said processor.

10. Monitoring device according to claim 9, wherein said interface (11a) comprises a first connector (19), complementary to a base (31) for connecting a plug (32) for connecting said disconnecting apparatus (30) to a control device (60) of said disconnecting apparatus, a second connector (20) comprising the configuration of said base (31) and groups together said signal pick-up means, between said first connector and second connector, said electronic circuit comprising point-to-point connections (70, 71, 72, 73, 74) between the connection points facing said first and second connectors.

11. Monitoring device according to claim 9 or 10 comprising a power supply provided by means of a branch (24, 25) connected to a power supply link (73, 74) of a sensor of the disconnecting apparatus.

12. Monitoring device according to any one of claims 9 to 11, wherein the signal acquisition and computing unit comprises a wireless or wired communication device (17) with a concentrator (80) controlling and monitoring said disconnecting apparatus and adapted to transmit to said concentrator monitoring data and operating parameters of said disconnecting apparatus generated by said signal acquisition and computing unit from measurements made by means of said sensors.

13. Monitoring device according to any one of claims 9 to 12, wherein said shock sensor (12a, 12b) is disposed in a housing (19a) of the signal acquisition and computing unit (10) or disposed on the disconnecting apparatus and connected to the signal acquisition and computing unit by a wired connection.

14. Computer program, comprising instructions for implementing all or part of the method according to any one of claims 1 to 8, when this program is executed by a processor.
